**Europäisches Patentamt**

**European Patent Office**

**Office européen des brevets**

(19)

(11) Veröffentlichungsnummer: **0 028 695**
**B1**

# EUROPÄISCHE PATENTSCHRIFT

(12)

(45) Veröffentlichungstag der Patentschrift:
08.01.86

(51) Int. Cl.⁴: **H 03 M 1/78**, H 03 M 1/00

(21) Anmeldenummer: **80105644.1**

(22) Anmeldetag: **19.09.80**

(54) **Schaltungsanordnung zur Umsetzung von Digital-Signalen, insbesondere von PCM-Signalen, in diesen entsprechende Analog-Signale, mit einem R-2R-Kettennetzwerk.**

(30) Priorität: **28.09.79 DE 2939455**

(43) Veröffentlichungstag der Anmeldung:
**20.05.81 Patentblatt 81/20**

(45) Bekanntmachung des Hinweises auf die Patenterteilung:
**08.01.86 Patentblatt 86/2**

(84) Benannte Vertragsstaaten:
**AT BE CH FR GB IT LI LU NL SE**

(56) Entgegenhaltungen:
DE - A - 2 423 130
DE - A - 2 901 484
DE - B - 2 315 986
DE - B - 2 838 310
FR - A - 2 043 946
US - A - 3 755 807

FUNK-TECHNIK, Band 30, Nr. 8, April 1975 R. REINER
"MOS-Integrierbare Digital-Analog-Wandler" Seiten 217 bis 219
ELEKTRONIK, Nr. 2, 1972 K.-D. REINIGER et al.
"Digital-Analog-Umsetzer mit FET-Schaltern" Seiten 39 bis 40
IEEE INTERNATIONAL SOLID-STATE CIRCUITS CONFERENCE DIGEST OF TECHNICAL PAPERS, 16. Februar 1978 Publisher, L. Winner E. PFRENGER et al.

(73) Patentinhaber: **Siemens Aktiengesellschaft, Berlin und München Wittelsbacherplatz 2, D-8000 München 2 (DE)**

(72) Erfinder: **von Sichart, Frithjof, Dr.,**
**Karl-Theodor-Strasse 72, D-8000 München 40 (DE)**
Erfinder: **Springstubbe, Wolf, Dipl.-Ing., Parkstrasse 15, D-8035 Gauting (DE)**

(56) Entgegenhaltungen: (Fortsetzung)
"A Companding D/A Converter for a Dual-Channel PCM CODEC" Seiten 186 bis 187
ELECTRONICS 45,5. Juni 1972 L. Altman "Bridging the Analog and Digital Worlds with Linear ICs" Seiten 83 bis 98

# Beschreibung

Die Erfindung bezieht sich auf eine Schaltungsanordnung zur Umsetzung von jeweils eine Anzahl von Bits umfassenden Digitalsignalen, insbesondere PCM-Signalen, in diesen entsprechende Analogsignale, unter Verwendung eines R-2R-Kettennetzwerks.

Ein solches R-2R-Kettennetzwerk kann in der Weise aufgebaut sein (siehe z.B. DE-AS 2 315 986), dass seine sämtlichen Längswiderstände und seine an den beiden Kettennetzwerksenden liegenden Querwiderstände jeweils ein und denselben Widerstandswert R besitzen, während alle übrigen Querwiderstände den doppelten Widerstandswert 2R besitzen, wobei das eine Ende des R-2R-Kettennetzwerks den Analogsignalausgang bildet; zur Umsetzung von jeweils $n+m+1$ Bits umfassenden Digitalsignalen in Analogsignale nach einer nichtlinearen Knickkennlinie, die aus $2^{m+1}$ linearen Abschnitten mit jeweils $2^n$ Amplitudenstufen besteht, kann dabei jedem Verbindungspunkt einer Gruppe von n benachbarten Verbindungspunkten jeweils eines Querwiderstandes und wenigstens eines Längswiderstandes selektiv ein Konstantstrom von einer von n Konstantstromquellen entsprechend den jeweils durch eine binäre «1» gebildeten n niederstwertigen Bits des jeweiligen Digitalsignals zuführbar sein, wobei der dem Analogsignalausgang zugewandte Verbindungspunkt der Gruppe von n benachbarten Verbindungspunkten von dem betreffenden Ende des R-2R-Kettennetzwerks einen Abstand entsprechend 1 bis $2^{m-1}$ Verbindungspunkten gemäss dem Wert der jeweils durch eine binäre «1» gebildeten m-Bits des jeweiligen Digitalsignals hat und wobei dem ihm in Richtung zu dem genannten Ende des R-2R-Kettennetzwerks benachbarten Verbindungspunkt eines Querwiderstandes und wenigstens eines Längswiderstandes ein Konstantstrom von einer gesonderten Konstantstromquelle in dem Falle zugeführt wird, dass wenigstens eines der m-Bits des jeweiligen Digitalsignals durch eine binäre «1» gebildet ist.

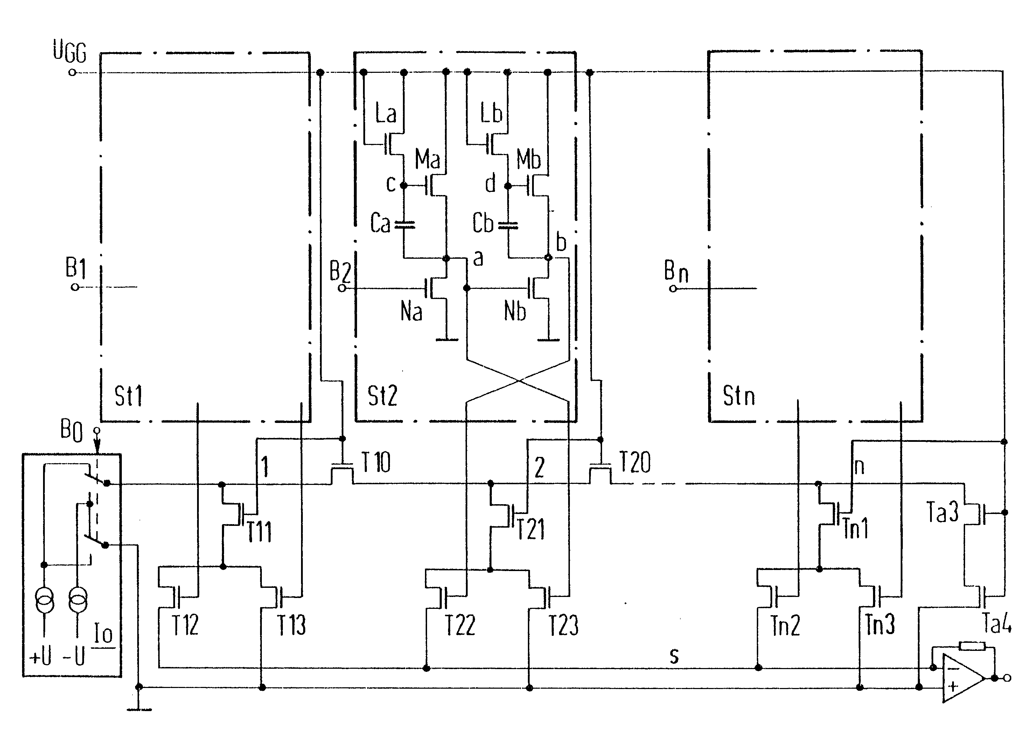

Ein solches R-2R-Kettennetzwerk kann aber auch in der Weise aufgebaut sein (siehe z.B. «Elektronik 21» (1972) 2, 39, 40, Bild 3; 1978 IEEE International Solid-State Circuits Conference, Digest auf Technical Papers, 186, 187, Fig. 2, oben), dass sämtliche Längswiderstände den Widerstandswert R und sämtliche Querwiderstände den Widerstandswert 2R besitzen, wobei das eine Ende des R-2R-Kettennetzwerks den Analogsignalausgang bildet und das andere Ende des R-2R-Kettennetzwerks durch einen zusätzlichen Widerstand des Widerstandswertes 2R abgeschlossen ist; zur Umsetzung eines Digitalsignals, das eine der Anzahl der Querwiderstände entsprechende Anzahl von Bits umfasst, sind dann an diejenigen Enden der Querwiderstände, die den Längswiderständen abgewandt sind, den Bits des Digitalsignals entsprechende Binärspannungen anschaltbar.

Das R-2R-Kettennetzwerk kann dabei in der Weise realisiert sein (siehe z.B. DE-OS 2 423 130 (VPA 74/6069); FR-PS 2 043 946), dass die den Widerstandswert R aufweisenden Längswiderstände durch die Quelle-Senke-Strecken von MOS-Transistoren gebildet sind, die stets im leitenden Zustand sind, und die den Widerstandswert 2R aufweisenden Querwiderstände durch die Quelle-Senke-Strecken jeweils zweier MOS-Transistoren bzw. zweier MOS-Transistorpaare zweier Gruppen von an gruppeneigene, unterschiedliche Spannungen abgebende Speisespannungsquellen angeschlossenen MOS-Transistoren gebildet sind, die von alternativ aktivierten Ausgängen jeweils einer Steuerschaltung her, der eingangsseitig jeweils ein Bit des jeweiligen Digitalsignals zuführbar ist, durch Ansteuerung an ihren Steuerelektroden mit dem gleichen Steuerpotential, das auch an den Steuerelektroden der Längswiderstände bildenden MOS-Transistoren liegt, alternativ in den leitenden Zustand steuerbar sind, wobei einem der beiden MOS-Transistoren (bzw. MOS-Transistorpaare), die diejenigen Querwiderstände des R-2R-Kettennetzwerks bilden, welche an dem vom Analogsignalausgang abgewandten Ende des Kettennetzwerks liegen, ein stets im leitenden Zustand befindlicher zusätzlicher MOS-Transistor (bzw. MOS-Transistorpaar) parallelgeschaltet ist.

Die Genauigkeit, mit der die Digital-Analog-Umsetzung vor sich geht, hängt bei einem solchen R-2R-Kettennetzwerk, abgesehen von den geometrischen Toleranzen der MOS-Transistoren, weitgehend von dem Einfluss der jeweiligen Steuerelektrode-Quelle-Spannung und Steuerelektrode-Senke-Spannung auf den Widerstand des leitenden MOS-Transistors ab; infolgedessen weichen die Widerstandswerte der einzelnen MOS-Transistoren in Abhängigkeit von der Bitkombination des jeweiligen Digitalsignals in unterschiedlichen Kombinationen von einem theoretisch einheitlichen Widerstandswert R in beiden Richtungen relativ stark ab, so dass die Digital-Analog-Umsetzung mit einem Fehler von bis zu 20% behaftet sein kann.

Schliesslich kann ein solches R-2R-Kettennetzwerk auch in der Weise ausgebildet sein (siehe z.B. «Electronics 45» (1972) 12, 83, 87, 90, Fig. 5; 1978 «IEEE International Solid-State Circuits Conference, Digist of Technical Papers», 186, 187, Fig. 2 unten), dass wiederum sämtliche Längswiderstände den Widerstandswert R und sämtliche Querwiderstände den Widerstandswert 2R besitzen, wobei an dem Verbindungspunkt des am einen Ende des R-2R-Kettennetzwerks liegenden Querwiderstandes und des ihm benachbarten Längswiderstandes ein Konstantstrom eingespeist wird und das andere Ende des R-2R-Kettennetzwerks durch einen zusätzlichen Widerstand des Widerstandswertes 2R abgeschlossen ist; zur Umsetzung eines Digitalsignals, das eine der Anzahl der Querwiderstände entsprechende Anzahl von Bits umfasst, sind dann diejenigen Enden der Querwiderstände, die den Längswiderständen abgewandt sind, den Bits des Digitalsignals entsprechend direkt an den Gegenpol der Konstantstromquelle oder an eine auf gleichem Potential gehaltene, den Analogsignalausgang bildende Summenstromleitung anschaltbar.

Die Widerstände des R-2R-Kettennetzwerks können hierbei durch MOS-Transistoren gebildet sein, wobei alle den Widerstandswert 2R aufweisenden MOS-Transistoren durch ein Paar von zwei gleichen, in Serie geschalteten MOS-Transistoren des Widerstandswertes R gebildet sind, und wobei zur Bildung der Querwiderstände jeweils zwei solcher Paare vorgesehen sind, die zwei Gruppen bilden, von denen die Paare der einen Gruppe zwischen dem betreffenden Verbindungspunkt von Längswiderstand und Querwiderstand und dem Fusspunkt der Konstantstromquelle und die Paare der anderen Gruppe zwischen diesem Verbindungspunkt und der Summenstromleitung liegen.

Auch ein solches R-2R-Kettennetzwerk ermöglicht eine exakte Digital-Analog-Umsetzung bei entsprechend exakter Realisierung des Widerstandswertes R in allen MOS-Transistoren, womit die Genauigkeit, mit der die Digital-Analog-Umsetzung vor sich geht — und die sich in der praktischen Realisierung bei einem stromquellengespeisten R-2R-Netzwerk, wie es momentan betrachtet wird, generell als höher erweist als bei einem spannungsquellengespeisten R-2R-Netzwerk, wie es zuvor erwähnt wurde —, wiederum von den geometrischen Toleranzen der MOS-Transistoren und von dem Einfluss der an den Transistoren auftretenden Spannungen auf die Widerstände der leitenden MOS-Transistoren abhängt. Dies würde eine den Source-Potentialen folgende transistorindividuelle Bemessung der Gate-Potentiale und damit eine entsprechend aufwendige Realisierung des R-2R-Kettennetzwerks erfordern.

Die Erfindung stellt sich demgegenüber die Aufgabe, von einer solchen exakten Realisierung des Widerstandswertes R in allen MOS-Transistoren des R-2R-Kettennetzwerks absehen zu können und dennoch Beeinträchtigungen der Genauigkeit der Digital/Analog-Umsetzung durch transistorspannungsbedingte Abweichungen der Widerstände leitender MOS-Transistoren von dem exakten Widerstandswert R weitestgehend zu vermeiden; dabei soll ausserdem ein Aufbau des R-2R-Kettennetzwerks ermöglicht werden, der auch mit einer geringeren Anzahl von MOS-Transistoren auskommt.

Die Erfindung betrifft somit eine Schaltungsanordnung zur Umsetzung von jeweils eine Anzahl von Bits umfassenden Digital-Signalen, insbesondere PCM-Signalen, in diesen entsprechende Analogsignale, mit einem Längswiderstände des Widerstandswertes R und Querwiderstände des Widerstandswertes 2R aufweisenden R-2R-Kettennetzwerk,

a) in das an dem Verbindungspunkt des an einem Ende des R-2R-Kettennetzwerks liegenden Querwiderstandes und des ihm benachbarten Längswiderstandes ein Konstantstrom eingespeist wird,

b) dessen anderes Ende durch einen zusätzlichen Widerstand des Widerstandswertes 2R abgeschlossen ist und

c) in dem zur Umsetzung eines Digitalsignals, das eine der Anzahl der Querwiderstände entsprechende Anzahl von Bits umfasst, diejenigen Enden der Querwiderstände, die den Längswiderständen abgewandt sind, den Bits des Digitalsignals entsprechend jeweils entweder direkt an den Gegenpol der Konstantstromquelle oder an eine (virtuell) auf gleichen Potential gehaltene, den Analogsignalausgang bildende Summenstromleitung anschaltbar sind,

d) wobei sämtliche Widerstände des R-2R-Kettennetzwerks durch die Quelle-Senke-Strekken von auf einen Chip integriert einzeln bzw. in Serie geschalteten untereinander gleichen MOS-Transistoren gebildet sind.

Diese Schaltungsanordnung ist erfindungsgemäss dadurch gekennzeichnet, dass die einzelnen Querwiderstände des R-2R-Kettennetzwerks jeweils durch die Quelle-Senke-Strecken zweier in Serie geschalteter MOS-Transistoren einer Sternschaltung von drei MOS-Transistoren gebildet sind, von denen der eine mit seiner den beiden anderen MOS-Transistoren abgewandten Hauptelektrode an dem betreffenden Verbindungspunkt von Längswiderstand und Querwiderstand des R-2R-Kettennetzwerks liegt, der zweite mit seiner den beiden anderen MOS-Transistoren abgewandten Hauptelektrode an dem Massepunkt der den Konstantstrom mit vom Digitalsignal bestimmtem Vorzeichen einspeisenden Konstantstromquelle liegt und der dritte mit seiner den beiden anderen MOS-Transistoren abgewandten Hauptelektrode an der Summenstromleitung liegt, wobei der zweite und der dritte MOS-Transistor von einer Steuerschaltung her, der eingangsseitig jeweils ein Bit des jeweiligen Digitalsignals zuführbar ist, durch Ansteuerung an ihren Steuerelektroden mit dem gleichen Steuerpotential, das an den Steuerelektroden sämtlicher genannter erster MOS-Transistoren und sämtlicher mit ihren Quelle-Senke-Strecken Längswiderstände des R-2R-Kettennetzwerkes bildenden, stets im leitenden Zustand befindlichen MOS-Transistoren liegt, alternativ in den leitenden Zustand steuerbar sind.

Die Erfindung bringt den Vorteil mit sich, dass ungeachtet etwa verbleibender unterschiedlicher Steuerelektrode-Quelle-Spannungen und Steuerelektrode-Senke-Spannungen und damit verbleibender Ungenauigkeiten in der Realisierung des Widerstandswertes R bzw. 2R die Digital-Analog-Umsetzung von solchen Fehlerquellen im Ergebnis praktisch unbeeinträchtigt bleibt und somit die Genauigkeit, mit der die Digital-Analog-Umsetzung vor sich geht, wesentlich erhöht ist.

Anhand eines in der Zeichnung dargestellten Ausführungsbeispiels wird die Erfindung nachstehend noch näher erläutert.

In der Zeichnung ist eine Schaltungsanordnung zur Umsetzung von jeweils einer Anzahl von Bits $B_0$, $B_1$, $B_2$,...$B_n$ umfassenden Digitalsignalen, insbesondere PCM-Signalen, in diesen entsprechend Analogsignale dargestellt, die als wesentlichen Bestandteil ein R-2R-Kettennetzwerk enthält, das mit untereinander gleichen MOS-Transistoren realisiert ist, die auf einem Chip integriert sein mögen.

Zu diesem R-2R-Kettennetzwerk gehören zum einen mit ihren Quelle-Senke-Strecken die Längswiderstände des R-2R-Kettennetzwerks bildende MOS-Transistoren T10, T20..., die durch N-Kanal-MOS-Transistoren vom Anreicherungstyp gebildet sein mögen; diese MOS-Transistoren liegen mit ihren Steuerelektroden an einer Steuerspannung $U_{GG}$ von beispielsweise + 12V, durch die sie stets im leitenden Zustand gehalten werden.

Bei diesem Kettennetzwerk sind die einzelnen Querwiderstände durch die Quelle-Senke-Strecken zweier in Serie geschalteter MOS-Transistoren einer Sternschaltung von drei MOS-Transistoren T11–T13;...; Tn1–Tn3 gebildet. Bei diesen Sternschaltungen liegt der eine Transistor T11, T21...Tn1 mit seiner den beiden anderen MOS-Transistoren T12, T13;... Tn2, Tn3 abgewandten Hauptelektrode an dem betreffenden Verbindungspunkt von Längswiderstand und Querwiderstand des R-2R-Kettennetzwerks. Der zweite MOS-Transistor T13, T23...Tn3 dieser Sternschaltung liegt mit seiner den beiden anderen MOS-Transistoren T11, T12...Tn1, Tn2 abgewandten Hauptelektrode am Massepunkt der den Konstantstrom mit vom Digitalsignal bestimmten Vorzeichen einspeisenden Konstantstromquelle Io und der dritte MOS-Transistor T12...Tn2 dieser Sternschaltung liegt mit seiner den beiden anderen MOS-Transistoren T11, T13...Tn1, Tn3 abgewandten Hauptelektrode an der Summenstromleitung s. Diese Summenstromleitung ist in der in der Zeichnung dargestellten Schaltungsanordnung mit dem invertierenden Eingang (−) eines als invertierender Verstärker geschalteten Operationsverstärkers verbunden, mit dessen nicht invertierendem Eingang (+) der Fusspunkt der Konstantstromquelle Io verbunden ist. Die Summenstromleitung s ist damit stets auf dem gleichen Potential (virtuelle Masse) gehalten wie der Fusspunkt der Konstantstromquelle Io. Die erwähnte Konstantstromquelle liefert beispielsweise einen Konstantstrom von 200 µA mit einem Vorzeichen, das vom Vorzeichenbit $B_0$ des jeweils umzusetzenden Digitalsignals bestimmt wird.

Eine solche Konstantstromquelle zur Erzeugung bipolarer Konstantströme kann grundsätzlich in (beispielsweise aus Elektronik 21, (1972)5, 165 167, Bild 12) bekannter Weise ausgebildet sein, weshalb hier nicht näher darauf eingegangen zu werden braucht.

Die Steuerschaltungen St1...Stn der Transistoren T12, T13...Tn2, Tn3 der Sternschaltungen können, wie dies in der Zeichnung für die Steuerschaltung St2 dargestellt ist, jeweils zwei in Kette geschaltete Inverter aufweisen, die durch MOS-Transistoren Na, Nb realisiert sind. Diese MOS-Transistoren Na, Nb liegen mit ihrer einen Hauptelektrode jeweils am Massepunkt der Konstantstromquelle während die andere Hauptelektrode jeweils über eine ebenfalls mit MOS-Transistoren Ma, La bzw. Mb, Lb realisierte Bootstrap-Schaltung Ca, La, Ma bzw. Cb, Lb, Mb mit einer die bereits erwähnte Steuerspannung $U_{GG}$ von beispielsweise + 12 V führenden Leitung verbunden sind. Sämtliche MOS-Transistoren der Steuerschaltungen St mögen dabei wiederum durch N-Kanal-MOS-Transistoren vom Anreicherungstyp gebildet sein.

Der Steuerelektrode des den einen Inverter bildenden MOS-Transisotrs Na wird das jeweils nach seiner Stellung innerhalb des umzusetzenden Digitalsignals in Frage kommende Bit $B_2$ zugeführt, indem in Zuführung eines Bits «1» ein Potential von beispielsweise + 10 V und in Zuführung eines Bits «0» ein Potential von beispielsweise 0 V an die Steuerelektrode des MOS-Transistors Na angelegt wird.

Im ersten Falle, d.h. bei Zuführung eines Bits «1», wird hierdurch der MOS-Transistor Na in den leitenden Zustand gebracht, wobei am Schaltungspunkt a ein Potential von etwa 0 V auftritt; zugleich ist der MOS-Transistor Ma leitend und zunächst auch der MOS-Transistor La, bis am Schaltungspunkt c ein Potential von etwa + 10 V auftritt. Zugleich damit wird der MOS-Transistor Nb in den Sperrzustand gebracht, wobei am Schaltungspunkt b ein Potential von + 12 V und am Schaltungspunkt d ein Potential von etwa + 20 V auftritt. Von der Steuerschaltung St2 her wird damit der mit seiner Steuerelektrode an den Schaltungspunkt b angeschlossenen MOS-Transistor T22 des R-2R-Kettennetzwerks in den leitenden Zustand gesteuert, während der mit seiner Steuerelektrode an den Schaltungspunkt a angeschlossenen MOS-Transistor T23 in den Sperrzustand gesteuert wird.

Im zweiten Falle, d.h. bei Zuführung eines Bits «0», wird der MOS-Transistor Na in den Sperrzustand gebracht, wobei sich am Schaltungspunkt c das Potential auf etwa + 20 V verschiebt und am Schaltungspunkt a das Potential von + 12 V auftritt, und zugleich damit wird der MOS-Transistor Nb in den leitenden Zustand gesteuert, wobei am Schaltungspunkt b das Potential von etwa 0 V und am Schaltungspunkt d das Potential von etwa + 10 V auftritt; von der Steuerschaltung St2 her wird dann der MOS-Transistor T23 in den leitenden Zustand gesteuert, während der MOS-Transistor T 22 in den Sperrzustand gelangt.

In entsprechender Weise können, ohne dass dies in der Zeichnung im einzelnen dargestellt wäre, auch die übrigen Steuerschaltungen St1,...Stn ausgebildet sein und damit auch in entsprechender Weise die mit ihnen verbundenen MOS-Transistoren des R-2R-Kettennetzwerks steuern.

Bei der in der Zeichnung dargestellten Realisierung der Steuerschaltungen St mit zwei in Kette geschalteten MOS-Transistor-Invertern, die jeweils mit einer Bootstrap-Schaltung verbunden sind, bewirken diese Bootstrap-Schaltungen, dass jeweils die volle Steuerspannung $U_{GG}$ an die Steuerelektrode des jeweils in den leitenden Zustand zu steuernden MOS-Transistors der Sternschaltung angeschaltet wird. Stattdessen könnten die Steuerschaltungen St gegebenenfalls aber auch in Abweichung von den in der Zeichnung dargestellten Verhältnissen in der Weise ausgebildet sein, dass die die Inverter bildenden MOS-Transistoren jeweils über einen als Lastwiderstand ausgenutzten N-Kanal-MOS-Transistor vom Verarmungstyp mit der die Steuerspannung $U_{GG}$ führenden Leitung verbunden sind. Derartige Steuerschaltungen sind grundsätzlich (aus der DE-OS 2 423 130) bekannt, weswegen hier nicht näher darauf eingegangen zu werden braucht. Des weiteren können als Steuerschaltung auch bistabile Kippschaltungen Verwendung finden, die entsprechende Lastelemente aufweisen, so dass wiederum gerade die volle Steuerspannung $U_{GG}$ an die Steuerelektroden des jeweiligen MOS-Transistors der Sternschaltung angeschaltet wird. Auch hierauf braucht an dieser Stelle nicht weiter eingegangen zu werden.

Von den Steuerschaltungen St1...Stn her, denen eingangsseitig die einzelnen Bits $B_1...B_n$ des umzusetzenden Digitalsignals zuführbar sind, erhält somit jeweils der eine MOS-Transistor Ti2 bzw. Ti3 der von der betreffenden Steuerschaltung Sti angersteuerten Sternschaltung an seiner Steuerelektrode die gleiche Steuerspannung $U_{GG}$, die auch an den Steuerelektroden der ständig leitenden MOS-Transistoren T10; T20... und Ti1 der Sternschaltungen Sti liegt; der jeweils andere MOS-Transistor Ti3 bzw. Ti2 der von der betreffenden Steuerschaltung Sti angesteuerten MOS-Transistor-Sternschaltung erhält an seiner Steuerelektrode eine unterhalb der Schwellenspannungen der MOS-Transistoren liegende Steuerspannung. Damit ist nach Massgabe des der betreffenden Steuerschaltung Sti jeweils zugeführten Bits $B_i$ des umzusetzenden Digitalsignals jeweils einer der beiden von dort angesteuerten Transistoren leitend, nämlich beim Auftreten eines Bits «0» der zum Gegenpol der Konstantstromquelle Io führende MOS-Transistor Ti3 und bei Auftreten eines Bits «1» der zu der virtuell auf gleichem Potential gehaltenen, den Analogsignalausgang bildenden Summenstromleitung s führende MOS-Transistor Ti2.

Dabei weichen unter dem Einfluss unterschiedlicher Steuerelektrode-Quelle-Spannungen und Steuerelektrode-Senke-Spannungen die Widerstandswerte der einzelnen MOS-Transistoren von einem für alle MOS-Transistoren einheitlichen Widerstandswert R mehr oder weniger stark ab, indem unter den gegebenen Verhältnissen bei positivem (negativem) Vorzeichen des von der Konstantstromquelle Io in das R-2R-Kettennetzwerk eingespeisten Konstantstromes der Widerstand jeweils des dem Längszweig des R-2R-Kettennetzwerkes zugewandten MOS-Transistors Ti1 einer in einem Querzweig des R-2R-Kettennetzwerkes liegenden MOS-Transistor-Sternschaltung grösser (kleiner) ist als der Widerstandswert des dem Längszweig des R-2R-Kettennetzwerks abgewandten MOS-Transistors Ti2 bzw. Ti3 der betreffenden MOS-Transistor-Sternschaltung. Durch die Beaufschlagung der Steuerelektroden der jeweils leitenden MOS-Transistoren in den Querzweigen und der Steuerelektrode der ständig leitenden MOS-Transistoren der Querzweige sowie der ständig leitenden, Längswiderstände bzw. den Abschlusswiderstand des R-2R-Kettennetzwerks bildenden MOS-Transistoren mit ein- und derselben Steuerspannung $U_{GG}$ in Verbindung mit der (virtuellen) Potentialgleichheit der den Analogsignalausgang bildenden Summenstromleitung s und des Fusspunktes der Konstantstromquelle Io ist jedoch erreicht, dass der Widerstandswert jedes einen Längswiderstand bildenden MOS-Transistors TiO gerade gleich dem Widerstandswert des mit ihm stromquellenseitig direkt verbundenen MOS-Transistors Ti1 der betreffenden Sternschaltung ist, während der Widerstandswert des jeweils von der betreffenden Steuerschaltung beeinflussten MOS-Transistors dieser Sternschaltung allenfalls bis auf vernachlässigbar kleine Abweichungen gleich dem Widerstandswert des jeweils verbleibenden, stromquellenabgewandten Teils des R-2R-Kettennetzwerks ist. Auf der Summenstromleitung s ergibt sich damit auf ein umzusetzendes Digitalsignal $B_0$, $B_1$, $B_2...B_n$ hin ein

$$\text{Summenstrom } I = \sum_{i=1}^{n} B_i \cdot I_o/2^i, \text{ der ein dem}$$

Digitalsignal entsprechendes Analogsignal darstellt.

Abschliessend sei noch bemerkt, dass das vorstehend beschriebene Ausführungsbeispiel von der Verwendung von N-Kanal-MOS-Transistoren ausgeht, dass stattdessen aber auch P-Kanal-MOS-Transistoren vom Anreicherungstyp Verwendung finden können, wobei dann eine Steuerspannung $U_{GG} = -12$ V vorzusehen wäre.

**Patentanspruch**

1. Schaltungsanordnung zur Umsetzung von jeweils eine Anzahl von Bits umfassenden Digitalsignalen, insbesondere PCM-Signalen, in diesen entsprechende Analogsignale mit einem Längswiderstände des Widerstandswertes R und Querwiderstände des Widerstandswertes 2R aufweisenden R-2R-Kettennetzwerk,

a) in das an dem Verbindungspunkt des an einem Ende des R-2R-Kettennetzwerks liegenden Querwiderstandes und des ihm benachbarten Längswiderstandes ein Konstantstrom eingespeist wird,

b) dessen anderes Ende durch einen zusätzlichen Widerstand des Widerstandswertes 2R abgeschlossen ist und

c) in dem zur Umsetzung eines Digitalsignals, das eine der Anzahl der Querwiderstände entsprechende Anzahl von Bits umfasst, diejenigen Enden der Querwiderstände, die den Längswiderständen abgewandt sind, den Bits des Digitalsignals entsprechend jeweils entweder direkt an den Massepunkt der Konstantstromquelle oder an eine virtuell auf gleichem Potential (virtuelle Masse) gehaltene, den Analogsignalausgang bildende Summenstromleitung anschaltbar sind,

d) wobei sämtliche Widerstände des R-2R-Kettennetzwerks durch die Quelle-Senke-Strekken von auf einem Chip integriert einzeln bzw. in Serie geschalteten, untereinander gleichen MOS-Transistoren gebildet sind, dadurch gekennzeichnet, dass die einzelnen Querwiderstände des R-2R-Kettennetzwerks jeweils durch die Quelle-Senke-Strecken zweier in Serie geschalteter MOS-Transistoren einer Sternschaltung von drei MOS-Transistoren (T11, T12, T13...Tn1, Tn2, Tn3) gebildet sind, von denen der eine (T11, T21,...Tn1) mit seiner den beiden anderen MOS-Transistoren abgewandten Hauptelektrode an dem betreffenden Verbindungspunkt von Längswiderstand und Querwiderstand des R-2R-Kettennetzwerks liegt, der zweite (T13, T23...Tn3) mit seiner den beiden anderen MOS-Transistoren abgewandten Hauptelektrode an dem Massepunkt der den Konstantstrom mit vom Digitalsignal bestimmtem Vorzeichen einspeisenden Konstantstromquelle (Io) liegt und der dritte (T12, T22...Tn2) mit seiner den beiden anderen MOS-Transistoren abgewandten Hauptelektrode an der Summenstromleitung (s) liegt, wobei der zweite und der dritte MOS-Transistor (T12, T13...Tn2, Tn3) von einer Steuerschaltung her, der eingangsseitig jeweils ein Bit des jeweiligen Digitalsignals zuführbar ist, durch Ansteuerung an ihren Steuerelektroden mit dem gleichen Steuerpotential, das an den Steuerelektroden sämtlicher genannter erster MOS-Transisotren (T11, T21...Tn1) und sämtlicher mit ihren Quelle-Senke-Strecken Längswiderstände des R-2R-Kettennetzwerkes bildenden, stets im leitenden Zustand befindlichen MOS-Transistoren (T10, T20...) liegt, alternativ in den leitenden Zustand steuerbar sind.

## Claim

1. A circuit arrangement for converting digital signals, each of which comprise a number of bits, in particular PCM signals, into corresponding analogue signals, with an R-2R-cascade (ladder) network consisting of series resistors having a resistance value R and shunt resistors having a resistance value 2R:-

a) into which a constant current is fed at the connection point between the shunt resistor located at one end of the R-2R-cascade network and the adjacent series resistor;

b) whose other end is terminated by an additional resistor having a resistance value 2R; and

c) in which the conversion of a digital signal which comprises a number of bits corresponding to the number of shunt resistors is effected by connecting those ends of the shunt resistors remote from the series resistors, in accordance with the bits of the digital signal, either directly to the earth point of the constant current source or to a sum current line held at virtually the same potential (virtual earth), and which forms the analogue signal output;

d) where all the resistors of the R-2R-cascade network are formed by the source-sink-paths of MOS-transistors which are identical to one another and are individually integrated or connected in series on a chip, characterised in that the individual shunt resistors of the R-2R-cascade network are each formed by the source-sink-paths of two series connected MOS transistors of a star circuit of three MOS-transistors (T11, T12, T13...Tn1, Tn2, Tn3), of which one (T11, T21,..Tn1) is connected, by its main electrode remote from the two other MOS-transistors, to the relevant connection point of the series resistor and shunt resistor of the R-2R-cascade network, the second (T13, T23..Tn3) is connected by its main electrode remote from the two other MOS-transistors, to the earth point of the constant current source (Io), which feeds in the constant current whose sign is determined by the digital signal, and the third (T12, T22...Tn2) is connected by its main electrode remote from the two other MOS-transistors, to the sum current line (s), where from a control circuit which can be supplied at its input with one bit of the particular digital signal, the second and third MOS-transistors (T12, T13..Tn2, Tn3) can be brought alternatively into the conductive state by being driven at their control electrodes with the same control potential which is connected to the control electrodes of all the aforementioned first MOS-transistors (T11, T21..Tn1) and all the MOS-transistors (T10, T20) whose source-sink-paths form series resistors of the R-2R-cascade network and which are constantly in the conductive state.

## Revendication

1. Montage pour convertir des signaux numériques comportant chacun un nombre de bits, notamment des signaux MIC, en des signaux analogiques correspondants, comportant un réseau itératif R-2R comportant des résistances longitudinales de valeur résistive R et des résistances transversales de valeur résistive 2R,

a) dans lequel un courant constant est injecté au niveau du point de jonction entre la résistance transversale, raccordée à une extrémité du réseau itératif R-2R, et la résistance longitudinale qui est voisine de cette résistance transversale,

b) dont l'autre extrémité est terminée par une résistance supplémentaire de valeur résistive 2R, et

c) dans lequel pour la conversion d'un signal numérique, qui comporte un nombre de bits correspondant au nombre de résistances transversales, les extrémités des résistances transversales, qui sont situées à l'opposé des résistances longitudinales, peuvent être raccordées, conformément aux bits du signal numérique, soit directement au point de masse de la source de courant constant, soit à une ligne de courant somme constituant la sortie des signaux analogiques et maintenue virtuellement à un même potentiel (masse virtuelle),

d) toutes les résistances du réseau itératif R-2R étant formées par les voies source-drain de transistors MOS identiques et branchés individuellement ou en série tout en étant intégrés sur une microplaquette, caractérisé par le fait que les différentes résistances transversales du réseau itératif R-2R sont formées respectivement par les voies source-drain de deux transistros MOS, branchés en série, d'un circuit en étoile de trois transistors MOS (T11, T12, T13,...Tn1, Tn2, Tn3), dont l'un (T11, T21,...Tn1) est raccordé par son électrode principale tournée à l'opposé des deux autres transistors MOS, au point de jonction concerné d'une résistance longitudinale et d'une résistance transversale du réseau itératif R-2R, et dont le second (T13, T23,...Tn3) est relié par son électrode principale, située à l'opposé des deux autres transistors MOS, au point de masse de la source de courant constant (Io) injectant le courant constant avec un signe déterminé par le signal numérique, et dont le troisième (T12, T22,..Tn2) est raccordé par son électrode principale située à l'opposé des deux autres transistors MOS, à la ligne de courant somme (s), le second et le troisième transistors MOS (T12, T13, Tn2, Tn3) pouvant être placés en alternance à l'état conducteur à partir d'un circuit de commande à l'entrée duquel peut être envoyé respectivement un bit du signal numérique respectif, au moyen d'une commande de ses électrodes de commande avec le même potentiel de commande que celui qui est présent sur les électrodes de commande de l'ensemble desdits premiers transistor MOS (T11, T21.. Tn1) et de tous les transistors MOS (T10, T20..) constituant, au moyen de leurs voies source-drain, des résistances longitudinales du réseau itératif (R-2R) qui sont placées en permanence à l'état conducteur.